# EUROPÄISCHE PATENTSCHRIFT

(11) **EP 0 842 494 B1**
(45) Veröffentlichungstag und Bekanntmachung des Hinweises auf die Patenterteilung: **07.03.2001**
(21) Anmeldenummer: 96927555.1
(22) Anmeldetag: 19.07.1996
(51) Int. Cl.: G06K 19/077, G06K 19/073

(54) **DATENTRÄGER MIT INTEGRIERTEM SCHALTKREIS**
DATA MEDIUM INCORPORATING INTEGRATED CIRCUITS
SUPPORT D'INFORMATION A CIRCUITS INTEGRES

(30) Priorität: 21.07.1995 DE 19526672
(43) Veröffentlichungstag der Anmeldung: 20.05.1998
(73) Patentinhaber: Giesecke & Devrient GmbH, 81667 München (DE)
(72) Erfinder: HAGHIRI-TEHRANI, Yahya, D-80797 München (DE)
(74) Vertreter: Klunker . Schmitt-Nilson . Hirsch
(86) Internationale Anmeldenummer: EP9603195
(87) Internationale Veröffentlichungsnummer: WO9704416

(56) Entgegenhaltungen:
- EP-A- 0 072 759
- EP-A- 0 417 887
- EP-A- 0 488 364
- EP-A- 0 587 011
- WO-A-94/29950
- WO-A-96/16378
- DE-A- 4 241 482

## Beschreibung

Die Erfindung betrifft einen Datenträger mit wenigstens zwei in einem Teilbereich des Datenträgers übereinander angeordneten integrierten Schaltkreisen, wobei zumindest einer der Schaltkreise über Kopplungselemente mit externen Geräten kommunizieren kann.

Datenträger mit eingebautem integrierten Schaltkreis sind bereits seit längerem bekannt und werden beispielsweise in Form einer Chipkarte z. B. als Zugangsberechtigung in innerbetrieblichen Zugangskontrollsystemen oder als Zahlungsmittel in öffentlichen Telefonzellen verwendet. Üblicherweise besteht eine derartige Chipkarte aus einem Kartenkörper und einem elektronischen Modul, das Kopplungselemente und einen leitend mit den Kopplungselementen verbundenen integrierten Schaltkreis umfaßt, der über die Kopplungselemente mit externen Geräten kommunizieren kann. Die Kopplungselemente sind hierbei üblicherweise als Kontaktflächen zur galvanisch berührenden Kommunikation oder als Spule zur berührungslosen Kommunikation ausgelegt.

Durch die immer komplexer werdenden Chipkartenanwendungen werden auch die integrierten Schaltkreise größer, wodurch die Bruchgefahr für die integrierten Schaltkreise im Datenträger steigt.

Deshalb wurde unter anderem verschiedentlich vorgeschlagen, die Funktionen eines größeren integrierten Schaltkreises auf mehrere kleine integrierte Schaltkreise zu verteilen. Die integrierten Schaltkreise sind hierbei üblicherweise auf dem elektronischen Modul entweder nebeneinander oder aber übereinander angeordnet.

Die DE-OS 29 42 397 zeigt beispielsweise ein derartiges elektronisches Modul, das in der Aussparung eines Datenträgers angeordnet werden kann. Das Modul weist ein Trägersubstrat auf, auf dessen einer Seite zwei integrierte Schaltkreise angeordnet sind und auf dessen anderer Seite ein dritter integrierter Schaltkreis angeordnet ist. Das Trägersubstrat weist auf der Seite des dritten integrierten Schaltkreises Kontaktflächen mit daran angeschlossenen Leiterbahnen auf, deren Enden leitend mit den Anschlußpunkten der integrierten Schaltkreise verbunden sind. Um die integrierten Schaltkreise ausgehend von den Kontaktflächen über die Leiterbahn verbinden zu können, ist das Trägersubstrat an mehreren Stellen durchkontaktiert.

Bei dem aus der DE-OS 29 42 397 bekannten elektronischen Modul ist die Bruchgefahr der einzelnen integrierten Schaltkreise verringert, jedoch muß ein Trägersubstrat mit einer relativ großen Fläche verwendet werden, da zwei integrierte Schaltkreise nebeneinander angeordnet werden. Darüber hinaus muß bei der Herstellung des elektronischen Moduls jeder integrierte Schaltkreis mit den Enden der besagten Leiterbahnen verbunden werden, was einen hohen Fertigungsaufwand erfordert. Auch die Herstellung der genannten Durchkontaktierung erfordert einen erhöhten Fertigungsaufwand. Zudem ist der Einbau des Moduls in den Datenträger erschwert, da auf beiden Seiten des Trägersubstrats integrierte Schaltkreise angeordnet sind.

Aus der europäischen Patentanmeldung EP-A-0 488 364 ist ein Verfahren und eine Vorrichtung zur Sicherung integrierter Schaltkreise gegen unauthorisierte Benutzung bekannt. Es wird dort vorgesehen, einen integrierten Schaltkreis, der eine bestimmte Funktion ausführen kann, mit einem zusätzlichen Schaltkreiselement zu versehen, welches nichts zu der auszuführenden Funktion beiträgt, sondern die gewünschte Funktion verhindert, wenn ein unauthorisierter Zugang versucht wird. Für den Fall, daß ein System mehrere diskrete integrierte Schaltkreise enthält, wird vorgesehen, daß jeder IC dieses zusätzliche Schaltkreiselement enthält. Es wird weiterhin vorgesehen, daß mehrere integrierte Schaltkreise zu einem Hybridschaltkreis zusammengefaßt werden.

Aus der nicht vorveröffentlichten internationalen Patentanmeldung WO 96/16378 ist eine Anordnung aus zwei integrierten Schaltkreisen, welche übereinander liegen und mittels kontaktloser Kopplung miteinander verbunden sind, bekannt. Aus diesem Dokument geht jedoch nicht hervor, daß eine derartige Anordnung in die Aussparung eines Datenträgers angeordnet wird.

Der Erfindung liegt deshalb die Aufgabe zugrunde, einen Datenträger anzugeben, der einfach und damit kostengünstig herstellbar ist.

Die Aufgabe wird mit dem Merkmalen der Ansprüche 1 und 14 gelöst.

Der Grundgedanke der Erfindung ist darin zu sehen, daß die beiden integrierten Schaltkreise über eine nichtgalvanische, kontaktlose Kopplung miteinander kommunizieren.

Hieraus ergeben sich mehrere Vorteile. So muß einer der beiden integrierten Schaltkreise nicht mehr leitend mit den Leiterbahnen auf dem Trägersubstrat verbunden werden, was zu einer Reduzierung des Fertigungsaufwandes führt. Weiterhin können die integrierten Schaltkreise räumlich getrennt übereinander angeordnet werden, ohne zur Kommunikation zwischen den beiden integrierten Schaltkreisen Durchkontaktierungen für leitende Verbindungen vorsehen zu müssen. Ferner ist es wesentlich schwieriger, die Kommunikation zwischen den integrierten Schaltkreisen abzuhören, da die integrierten Schaltkreise kontaktlos miteinander kommunizieren.

Gemäß einer ersten Ausführungsform eines erfindungsgemäßen Datenträgers werden die beiden integrierten Schaltkreise direkt aneinander angrenzend übereinander angeordnet. Vorzugsweise können die beiden integrierten Schaltkreise dabei über eine Kleberschicht miteinander verbunden sein. Die Mittel zur Kommunikation zwischen den integrierten Schaltkreisen sind bevorzugt auf aufeinander zugewandten Flächen der integrierten Schaltkreise angeordnet. Derartige Mittel können beispielsweise Spulen, kapazitive Elemente oder Optokoppler sein. Die Mittel können sich hierbei entweder außerhalb der integrierten Schaltkreise befinden oder aber auch monolithisch in den integrierten Schaltkreisen integriert sein.

In einer zweiten Ausführungsform werden die beiden integrierten Schaltkreise räumlich getrennt im Datenträger angeordnet. Eine Möglichkeit hierzu ist es, einen ersten Schaltkreis in einer Aussparung des Datenträgers anzuordnen. Der erste Schaltkreis ist dazu beispielsweise auf einem an sich bekannten elektronischen Modul angeordnet, kann aber auch ohne elektronisches Modul in der Aussparung angeordnet sein, wobei die Kopplungselemente zur Kommunikation mit externen Geräten dann monolithisch im integrierten Schaltkreis integriert sind. Der zweite integrierte Schaltkreis kann auf der dem ersten integrierten Schaltkreis gegenüberliegenden Seite des Datenträgers in einer zweiten Aussparung des Datenträgers angeordnet sein. Die Mittel zur Kommunikation zwischen den integrierten Schaltkreisen sind hierbei entweder Spulen oder kapazitive Elemente, die sich entweder außerhalb der integrierten Schaltkreise befinden oder aber monolithisch integriert sind.

Alternativ kann aber auch einer der integrierten Schaltkreise oder beide Schaltkreise integraler Bestandteil jeweils eines Selbstklebeetiketts sein, das dann entweder auf der dem jeweils anderen integrierten Schaltkreis gegenüberliegenden Seite des Datenträgers oder auf der gleichen Seite aufgeklebt ist, so daß für den betreffenden Schaltkreis keine Aussparung im Datenträger mehr erforderlich ist.

Weitere Vorteile und Weiterbildungen der Erfindung werden in den folgenden Figuren gezeigt.

Hierin zeigen:
- Fig. 1: erfindungsgemäßer Datenträger,
- Fig. 2: Datenträger gemäß Fig. 1 im Schnitt mit direkt aneinandergrenzenden integrierten Schaltkreisen,
- Fig. 3: Schnitt eines noch nicht fertiggestellten elektronischen Moduls zur Herstellung eines Datenträgers gemäß Fig. 1 und 2,
- Fig. 4: Schnitt einer Vergußform zur Herstellung eines elektronischen Moduls nach Fig. 3
- Fig. 5 und 6: Schnitt eines elektronischen Moduls nach Fig. 3 mit zusätzlichen elektronischem Schutzmantel,
- Fig. 7: Schnitt eines zweiten Ausführungsbeispiels eines Datenträgers mit direkt aneinandergrenzenden integrierten Schaltkreisen,
- Fig. 8: erfindungsgemäßer Datenträger mit räumlich getrennten integrierten Schaltkreisen,
- Fig. 9: integrierter Schaltkreis 7 gemäß Fig. 8 mit zusätzlichem elektronischen Schutzmantel,
- Fig. 10 - 13: xnoch nicht fertiggestellte elektronische Module zur Herstellung eines Datenträgers gemäß Fig. 1 - 6 und Fig. 8.

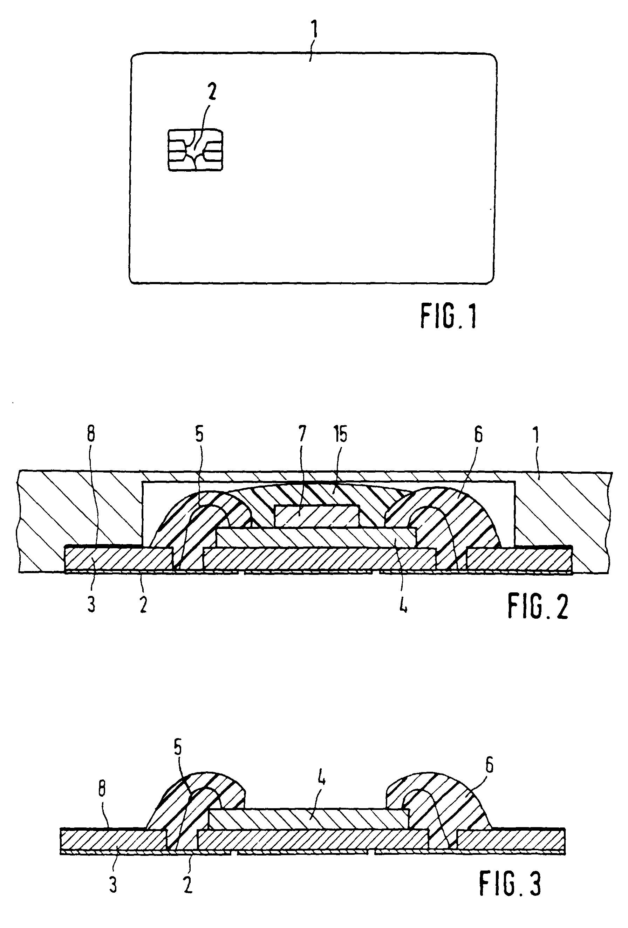

Fig. 1 zeigt einen erfindungsgemäßen Datenträger. Der Datenträger umfaßt einen Kartenkörper 1 und Kopplungselemente in Form von Kontaktflächen 2, über die wenigstens einer der integrierten Schaltkreise, die sich im Inneren des Datenträgers befinden, mit externen Geräten kommunizieren kann.

Fig. 2 zeigt den Schnitt einer ersten Ausführungsform eines erfindungsgemäßen Datenträgers, bei dem zwei integrierte Schaltkreise 4 und 7 direkt aneinander angrenzend übereinander angeordnet sind. Die integrierten Schaltkreise sind über eine hier nicht gezeigte Kleberschicht miteinander verbunden und können über eine nichttgalvanische, kontaktlose Kopplung miteinander kommunizieren. Hierbei ist die Kopplung zwischen den integrierten Schaltkreisen auf den einander zugewandten Flächen der integrierten Schaltkreise angeordnet. Bei der besagten Kopplung handelt es sich um Spulen oder um kapazitive Elemente oder um Optokoppler.

Die integrierten Schaltkreise 4 und 7 sind auf dem Trägersubstrat 3 eines elektronischen Moduls angeordnet. Auf der den integrierten Schaltkreisen 4 und 7 gegenüberliegenden Seite des Trägersubstrats 3 sind Kopplungselemente zur Kommunikation mit externen Geräten in Form von metallischen Kontaktflächen 2 vorgesehen, die über leitende Verbindungen, hier Bonddrähtchen 5, mit Anschlußpunkten des integrierten Schaltkreises 4 verbunden sind.

Damit kann der integrierte Schaltkreis 4 über die Kopplungselemente - hier die Kontaktflächen 2 - mit externen Geräten kommunizieren. Die nichtgalvanische kontaktlose Kopplung der integrierten Schaltkreise 7 und 4 kann derart ausgestaltet werden, daß der Zugriff durch externe Geräte auf den zweiten integrierten Schaltkreis 7 nur über den ersten integrierten Schaltkreis 4 möglich ist. Weiterhin können die Funktionen der Schaltkreise 4 und 7 so aufeinander abgestimmt werden, daß der Datenträger bestimmte Sicherheitsfunktionen nur dann erfüllt, wenn wenigstens einer der beiden Schaltkreise 4 und 7 in unverfälschter Form eingekoppelt ist.

Die integrierten Schaltkreise 4 und 7 sowie die Bonddrähtchen 5 sind zum Schutz vor mechanischen Belastungen durch eine Vergußmasse 6 und 15 vergossen. Das elektronische Modul ist über eine Kleberschicht 8 mit dem Kartenkörper 1 verklebt.

Natürlich muß das elektronische Modul nicht über zwei Vergußmassen vergossen sein, sondern es können auch beide integrierte Schaltkreise über eine Vergußmasse bedeckt werden.

Fig. 3 zeigt ein noch nicht fertiggestelltes elektronisches Modul zum Einbau in einen Datenträger gemäß Fig. 1 und 2 im Schnitt. Bei dem besagten Modul sind Teilbereiche des integrierten Schaltkreises - hier die Ränder des integrierten Schaltkreises 4 sowie die Bonddrähtchen 5 - vergossen, wobei ein zentraler Teil auf der Oberfläche des integrierten Schaltkreises 4 frei von Vergußmasse ist. Bei dem Modul ergibt sich der besondere Vorteil, daß der integrierte Schaltkreis 7 problemlos nachträglich auf dem Modul angeordnet werden kann, da die Bonddrähtchen 5 sehr gut vor mechanischen Belastungen geschützt sind, so daß das Modul gut lagerbar oder transportierbar ist.

Die Fertigstellung des besagten elektronischen Moduls gemäß Fig. 3 erfolgt, indem der zweite integrierte Schaltkreis 7 beispielsweise mit einem Kleber auf dem ersten integrierten Schaltkreis 4 angeordnet und der verbleibende Hohlraum um den integrierten Schaltkreis 7 herum mit einer Vergußmasse 15 aufgefüllt wird.

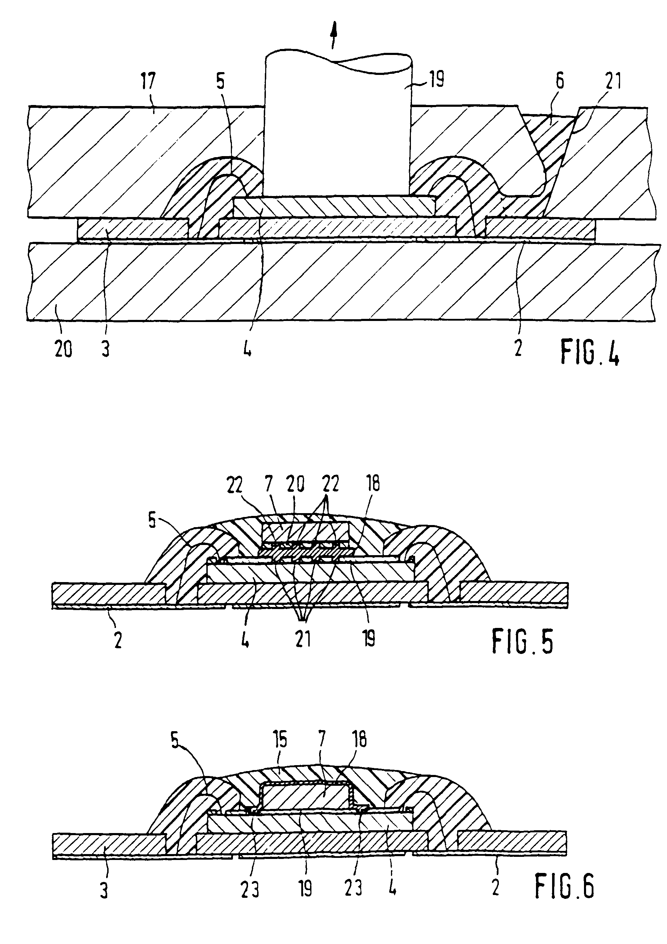

Die Herstellung des Vergusses 6 erfolgt über eine Gußform, wie sie im Schnitt in Fig. 4 dargestellt ist. Die Gußform besteht im wesentlichen aus zwei Gußformhälften 17 und 20, wobei die Gußformhälfte 20 vollkommen eben ausgebildet ist und die Gußformhälfte 17 einen Formhohlraum aufweist. In der Gußformhälfte 17 ist mittig im Formhohlraum zusätzlich ein beweglicher Stempel 19 vorgesehen, der verhindert, daß beim Vergießen des Moduls der zentrale innere Teil des Formhohlraums mit Vergußmasse aufgefüllt wird. Die Gußformhälften und der Stempel sind vorzugsweise aus Stahl gefertigt, können aber auch aus einem anderen Material bestehen. Das Vergießen des Moduls geht dabei in folgenden Schritten vor sich. Die Gußformhälften 17 und 20 werden auf dem elektronischen Modul aufgesetzt, wobei der bewegliche Stempel 19 nach dem Aufsetzen auf den integrierten Schaltkreis 4 in die Formhälfte 17 zurückweicht, um eine Zerstörung des integrierten Schaltkreises 4 zu verhindern. In einem nächsten Schritt wird über den Angußkanal 21 in die Gußformhälfte 17 die flüssige Vergußmasse 6 eingespritzt, wodurch der zwischen Gußformhälfte 17 und dem elektronischen Modul verbleibende Hohlraum mit der Vergußmasse 6 aufgefüllt wird. Nach dem Erhärten der Vergußmasse 6 werden die Gußformhälften 17 und 20 wieder entfernt. Eventuell verbleibende Reste von Vergußmasse im Bereich des sehr schmal ausgeführten Angußkanals 21 können einfach durch Abbrechen entfernt werden.

Für den Fall, daß einer der integrierten Schaltkreise 4 und 7 oder beide Schaltkreise Sicherheitsfunktionen enthalten, und die integrierten Schaltkreise deshalb gegen ein mißbräuchliches Trennen geschützt werden müssen, können entsprechende Mittel vorgesehen werden, die bei einem mißbräuchlichen Trennen der integrierten Schaltkreise einen oder beide integrierten Schaltkreise unbrauchbar machen, so daß diese nicht mehr verwendbar sind. So kann beispielsweise ein piezo-elektrisches Material verwendet werden, dessen Enden leitend mit einer Schutzschaltung in einem der integrierten Schaltkreise oder in beiden Schaltkreisen verbunden ist. Bei einem mißbräuchlichen Trennen der integrierten Schaltkreise tritt eine Verformung des piezo-elektrischen Materials auf, wodurch eine Spannung erzeugt wird, durch die in dem/bzw. den integrierten Schaltkreis/en beispielsweise Daten im Speicher des betreffenden integrierten Schaltkreises gelöscht werden.

Ein elektronisches Modul gemäß Fig. 2 mit einem derartigen elektronischen Schutzmantel ist in Fig. 5 zu sehen. Hierin ist zwischen den integrierten Schaltkreisen 4 und 7 ein solcher elektronischer Schutzmantel 18 in Form eines piezo-elektrischen Materials vorgesehen. Der elektronische Schutzmantel 18 durchdringt hierbei die im Halbleiterherstellungsprozeß gefertigten Isolationsschichten 19 und 20 der integrierten Schaltkreise 4 und 7 an den Stellen 21 und 22 und ist an den besagten Stellen leitend mit Schutzschaltungen in den integrierten Schaltkreisen verbunden. Beim Entfernen des integrierten Schaltkreises 7 entsteht so zwischen den Anschlußpunkten 21 sowie auch zwischen den Anschlußpunkten 22 eine elektrische Spannung, die in den integrierten Schaltkreisen 4 und 7 zu einem Löschen der darin enthaltenen Speicher führt.

Fig. 6 zeigt eine andere Ausführungsvariante eines elektronischen Moduls gemäß Fig. 2 mit elektronischem Schutzmantel. Der elektronische Schutzmantel ist hierbei nur leitend durch Durchbrechungen in der Isolationsschicht 19 im integrierten Schaltkreis 4 mit einer Schutzschaltung verbunden, so daß beim Trennen der integrierten Schaltkreise 4 und 7 nur der integrierte Schaltkreis 4 deaktiviert wird.

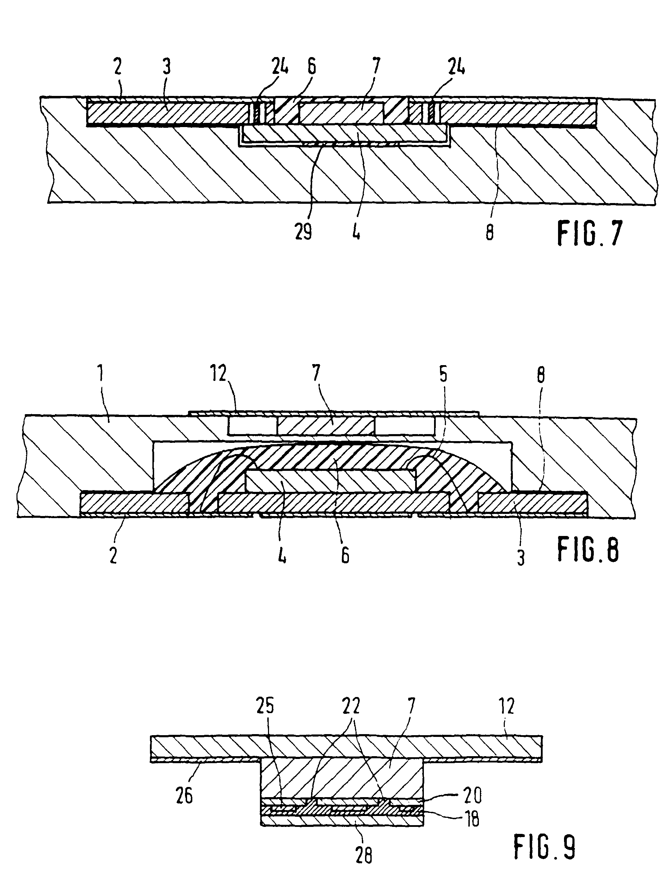

Eine anderes Ausführungsbeispiel eines elektronischen Moduls im Schnitt, bei dem zwei integrierte Schaltkreise direkt aneinander angrenzend übereinander angeordnet sind, zeigt Fig. 7. Das hierin gezeigte elektronische Modul unterscheidet sich nur geringfügig von den vorhergehend gezeigten elektronischen Modulen. Es umfaßt ebenfalls Kontaktflächen 2, die durch Durchbrechungen im Trägersubstrat 3 hindurch mit dem integrierten Schaltkreis 4 leitend verbunden sind. Die Kontaktierung zwischen Kontaktflächen 2 und integriertem Schaltkreis 4 erfolgt hierbei im Flip-Chip-Verfahren, das aus dem Stand der Technik hinreichend bekannt ist und auf das hier nicht näher eingegangen werden soll. Der integrierte Schaltkreis 7 ist hierbei auf der dem Trägersubstrat zugewandten Seite des integrierten Schaltkreises 4 in einer Durchbrechung des Trägersubstrates angeordnet. Der verbleibende Hohlraum ist mit der Vergußmasse 6 aufgefüllt. Um den unvergossenen integrierten Schaltkreis 4 zu puffern, ist in der Aussparung des Datenträgers 1 zusätzlich eine elastische Masse 29, wie beispielsweise Silikon, angeordnet.

Das durch Fig. 7 gezeigte elektronische Modul hat gegenüber den vorher gezeigten Modulen einige Vorteile. So ist die Gesamthöhe des Moduls wesentlich geringer als diejenige der vorhergehenden Module, da der zweite integrierte Schaltkreis 7 in der Aussparung des Trägersubstrates 3 angeordnet ist. Somit ist die Gesamthöhe des Trägersubstrates um die Höhe des zweiten integrierten Schaltkreises 7 verringert. Darüber hinaus ist der zweite integrierte Schaltkreis sehr einfach zu vergießen, da kein Vergußrahmen benötigt wird. Das Vergießen beschränkt sich lediglich auf das Auffüllen des verbleibenden Hohlraumes im Bereich des integrierten Schaltkreises 7 mit der Vergußmasse 6.

In einem dritten besonders einfachen Ausführungsbeispiel eines elektronischen Moduls mit zwei direkt aneinander angrenzenden, übereinander angeordneten integrierten Schaltkreisen, das hier nicht gezeigt wird, besteht das elektronische Modul ausschließlich aus zwei integrierten Schaltkreisen, wobei hierbei sowohl die Kopplungselemente zur Kommunikation mit externen Geräten wie auch die Kopplungselemente zur nichtgalvanischen, kontaktlosen Kopplung zum jeweils anderen integrierten Schaltkreis monolithisch in den Schaltkreisen integriert sind. Damit müssen lediglich die beiden integrierten Schaltkreise miteinander verklebt und in einem Hohlraum des Kartenkörpers 1 angeordnet werden.

Fig. 8 zeigt eine grundsätzliche zweite Ausführungsform eines erfindungsgemäßen Datenträgers im Schnitt, bei dem die beiden integrierten Schaltkreise 4 und 7 räumlich getrennt im Datenträger angeordnet sind. Hierbei ist in einer ersten Aussparung des Kartenkörpers ein elektronisches.Modul 17 angeordnet. Das elektronische Modul ist im wesentlichen genauso wie das oben beschriebene elektronische Modul gemäß Fig. 2 aufgebaut und unterscheidet sich nur darin, daß der integrierte Schaltkreis 7 nicht auf dem elektronischen Modul angeordnet ist. Der zweite integrierte Schaltkreis 7 ist auf der dem ersten integrierten Schaltkreis 4 gegenüberliegenden Seite des Datenträgers in einer zweiten Aussparung angeordnet. Diese zweite Aussparung ist in dem gezeigten Beispiel durch ein Selbstklebeetikett 12 abgeklebt, kann jedoch statt dessen auch durch eine opake Vergußmasse aufgefüllt sein.

Sollten in dem integrierten Schaltkreis 7 sicherheitsrelevante Daten vorhanden sein, so kann auch der integrierte Schaltkreis 7 mit einem elektronischen Schutzmantel 18 versehen werden, wie dies Fig. 9 zeigt. Der elektronische Schutzmantel ist hierbei ähnlich wie in Fig. 5 durch Durchbrechungen in einer Isolationsschicht 20 hindurch leitend mit dem integrierten Schaltkreis 7 verbunden. Zusätzlich befinden sich zwischen dem elektronischen Schutzmantel 18 und der Isolationsschicht 20 Silikonbahnen 25, die aus untengenannten Gründen als Trennmittel zwischen der Isolationsschicht 20 und dem elektronischen Schutzmantel 18 wirken, so daß der elektronische Schutzmantel 18 und die Isolationsschicht 20 nur leicht aneinanderhaften. Ferner ist der integrierte Schaltkreis 7 fest mit dem Selbstklebeetikett 12 verklebt, so daß der integrierte Schaltkreis 7 und das Etikett 12 eine feste Einheit in Form eines Sicherheitsetiketts 27 ergeben. Das Sicherheitsetikett wird über die Kleber 26, 28 (z. B. Haftkleber oder Hotmelt-Kleber) ähnlich wie in Fig. 8 in die Aussparung des Kartenkörpers 1 eingeklebt. Sollte nach dem Einkleben des Sicherheitsetiketts 27 versucht werden, das Sicherheitsetikett 27 aus dem Datenträger 1 zu entfernen, so löst sich der über den Kleber 28 fest mit dem Datenträger 1 verklebte elektronische Schutzmantel 18 - bedingt durch die Silikonbahnen 25 - von der Isolationsschicht 20 des integrierten Schaltkreises 7. Hierdurch wird an den Anschlußpunkten 22, wie oben bereits ausführlich erläutert, eine Spannung erzeugt, wodurch beispielsweise sensitive Daten im Speicher des integrierten Schaltkreises 7 gelöscht werden.

In einer hier nicht gezeigten Weiterbildung eines Datenträgers mit räumlich getrennt voneinander angeordneten integrierten Schaltkreisen kann der zweite integrierte Schaltkreis 7 integraler Bestandteil eines Selbstklebeetiketts sein, das entweder auf der dem ersten integrierten Schaltkreis gegenüberliegenden Seite oder auf derselben Seite des Datenträgers aufgeklebt ist. Derartige Selbstklebeetiketten mit darin integrierten Schaltkreisen sind dem Fachmann bereits seit längerem bekannt und sollen hier nicht näher erläutert werden. Die Verwendung von derartigen Selbstklebeetiketten hat den Vorteil, daß für den integrierten Schaltkreis 7 keine zusätzliche Aussparung im Datenträger vorgesehen werden muß. Zusätzlich kann natürlich auch hierbei, ähnlich wie bei den obengenannten Ausführungsformen, ein elektronischer Schutzmantel vorgesehen werden.

Natürlich kann der in der in Fig. 8 gezeigte erste integrierte Schaltkreis 4 integraler Bestandteil eines Selbstklebeetiketts sein, so daß der Kartenkörper 1 überhaupt keine Aussparung mehr aufweisen muß. Für diesen Fall können die beiden Selbstklebeetiketten auf der gleichen Seite des Datenträgers oder auf gegenüberliegenden Seiten des Datenträgers aufgeklebt werden.

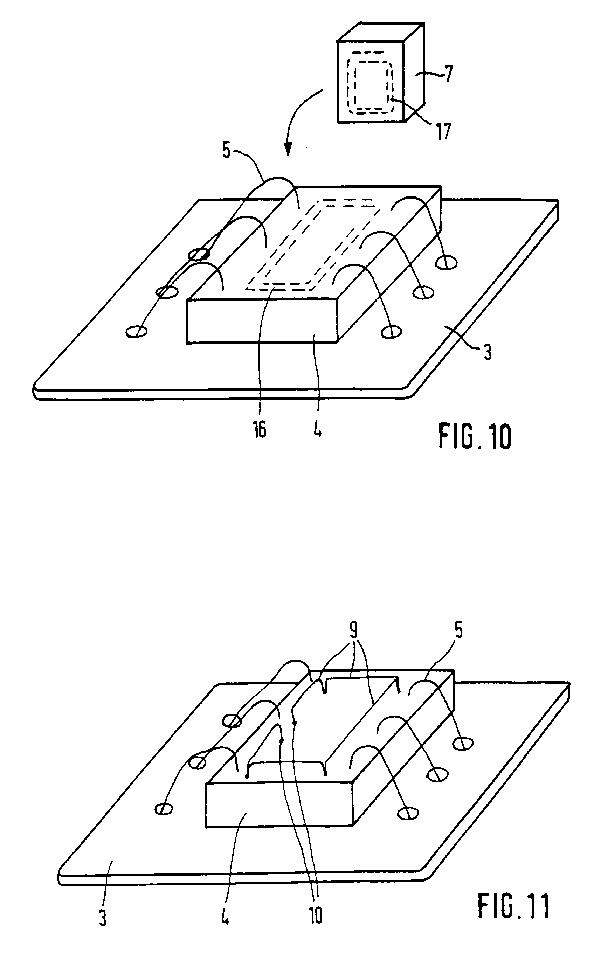

Fig. 10 zeigt ein noch nicht fertiggestelltes elektronisches Modul in einer perspektivischen Darstellung, wie es zur Herstellung der elektronischen Module gemäß Fig. 1 - 6 und Fig. 8 verwendet werden kann, zusammen mit dem zweiten integrierten Schaltkreis 7, der entweder direkt auf dem integrierten Schaltkreis 4 angeordnet werden kann oder räumlich getrennt im Datenträger. Sowohl der integrierte Schaltkreis 4 wie auch der integrierte Schaltkreis 7 weisen als Elemente zur kontaktlosen, nichtgalvanischen Kommunikation mit dem anderen Schaltkreis monolithisch integrierte Spulen 16 und 17 auf. Ein elektronisches Modul zum Einbau in einen Datenträger gemäß Fig. 2 wird wie folgt fertiggestellt. In einem ersten Schritt wird der Randbereich des integrierten Schaltkreises 4 mit der in Fig. 4 gezeigten Vergußform mit der Vergußmasse 6 vergossen. In einem zweiten Schritt wird der integrierte Schaltkreis 7 aufgesetzt und der verbleibende Hohlraum mit der Vergußmasse 15 aufgefüllt. In einem letzten Schritt wird der Haftkleber 8 aufgebracht. Natürlich kann der Schritt des Vergusses vom Randbereich des integrierten Schaltkreises 4 auch entfallen. Die beiden übereinander angeordneten Schaltkreise werden dann gemeinsam in einem analogen Verfahren, wie nachfolgend im Zusammenhang mit der Herstellung eines elektronischen Moduls für einen Datenträger gemäß Fig. 8 beschrieben, vergossen.

Zur Herstellung eines elektronischen Moduls 17 gemäß Fig. 8 wird in einem ersten Schritt ein Haftklebering aufgebracht. In einem zweiten Schritt wird der integrierte Schaltkreis 4 mit einer Vergußmasse 6 vergossen, wobei der Haftklebering als Vergußrahmen für die Vergußmasse fungiert.

Die Fig. 11 - 13 zeigen die perspektivische Darstellung weiterer Ausführungsformen von noch nicht fertiggestellten elektronischen Modulen, wie sie zur Herstellung der Datenträger gemäß den Fig. 1 - 6 und Fig. 8 verwendet werden können. Die Fertigstellung der elektronischen Module für den Einbau in einen Datenträger gemäß Fig. 2 oder 8 erfolgt analog wie in Zusammenhang mit Fig. 10 beschrieben.

Die Ausführungsform nach Fig. 11 weist eine Spule 9 zur nichtgalvanischen kontaktlosen Kommunikation mit dem zweiten integrierten Schaltkreis 7 auf. Die Spule 9 besteht hierbei aus einer Vielzahl von Bonddrähtchen, deren Enden jeweils leitend mit dafür vorgesehenen Punkten des integrierten Schaltkreises verbunden sind. Die Spule 9 wurde hierbei hergestellt, indem Bonddrähtchen mehrere auf der Oberfläche des integrierten Schaltkreises vorhandene metallisierte Flächen verbinden, wobei das Ende eines Bonddrähtchens jeweils durch die Metallisierung leitend mit dem nächsten Bonddrähtchen verbunden ist. Die Anschlußpunkte 10 stellen hierbei die Anschlußpunkte dar, die den integrierten Schaltkreis 4 mit der Spule 9 verbinden. Zur Fertigstellung eines elektronischen Moduls gemäß Fig. 2 muß dabei darauf geachtet werden, daß der Schaltkreis 7 innerhalb der Spule 9 angeordnet wird.

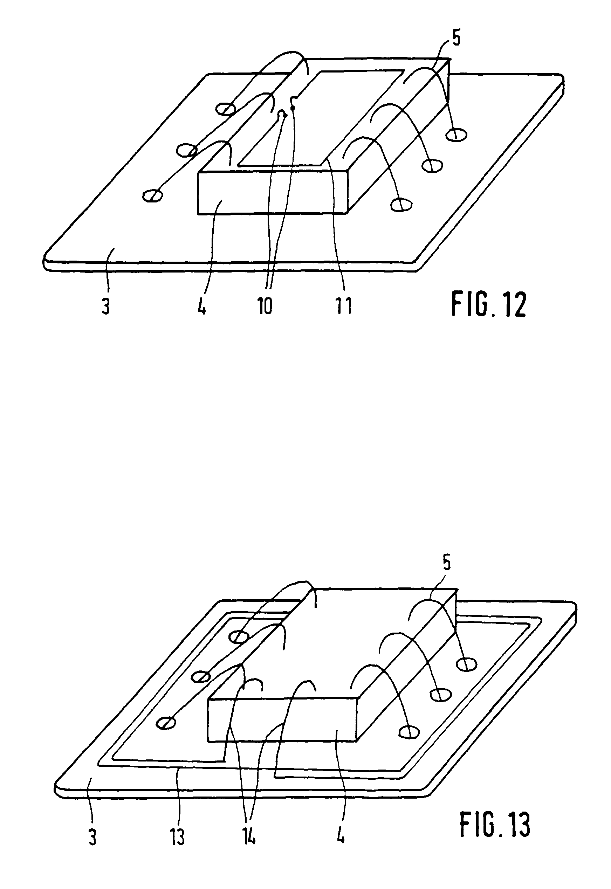

Die Ausführungsform nach Fig. 12 zeigt im Gegensatz zum Modul gemäß Fig. 11 eine Spule 11, die aus einem einzigen Bonddrähtchen gefertigt ist. Der Bonddraht ist auf der Oberfläche des integrierten Schaltkreises angeordnet und leitend mit den Anschlußpunkten des integrierten Schaltkreises verbunden. Zur Fertigung der Spule 11 wird auf dem integrierten Schaltkreis ein dem Fachmann bereits hinreichend bekannter Adhäsionskleber aufgebracht. Das Bonddrähtchen wird daraufhin an einem der Anschlußpunkte 10 angebondet und jeweils an den Eckpunkten der Spule 11 abgesetzt, wodurch die Spule an den betreffenden Punkten am Adhäsionskleber anhaftet. Schließlich wird das Ende des Bonddrähtchens an dem zweiten Anschlußpunkt 10 des integrierten Schaltkreises 4 festgebondet. Bei der Fertigstellung eines elektronischen Moduls gemäß Fig. 2 ist der Schaltkreis 7 ebenfalls innerhalb der Spule 11 anzuordnen.

Die Ausführungsform gemäß Fig. 13 weist eine Spule 13, zur nichtgalvanischen kontaktlosen Kopplung zum zweiten integrierten Schaltkreis 7 auf, die auf einem Spulenträger des Moduls - hier dem Trägersubstrat 3 - angeordnet und leitend über Bonddrähtchen 14 mit den entsprechenden Anschlußpunkten des integrierten Schaltkreises 4 verbunden ist. Die Spule 13 wurde hier in diesem speziellen Ausführungsbeispiel hergestellt, indem aus einer auf der Seite des integrierten Schaltkreises 4 vorhandenen metallischen Schicht die entsprechende Spule ausgeätzt wurde.

Es ist für den Fachmann offensichtlich, daß die gezeigten elektronischen Module nur beispielhaften Charakter haben. So können die elektronischen Module beispielsweise auch in anderen Techniken, z. B. der Leadframe-Technik gefertigt sein, wodurch dann das Trägersubstrat 3 entfallen kann. Darüber hinaus können die Kopplungselemente zur Kommunikation mit externen Geräten auch anders ausgebildet sein, beispielsweise als kapazitive Elemente, induktive Elemente oder als Optokoppler. Ferner muß auch die Verbindung zu dem integrierten Schaltkreis 4 und den Kontaktflächen 2 nicht über Bonddrähtchen 5 erfolgen und kann auch anders ausgestaltet sein, wie beispielsweise in TAB-Technik. Natürlich können auch die nicht mit elektronischen Schutzmantel gezeigten Module ebenfalls einen solchen aufweisen.

## Patentansprüche

1. Datenträger mit mindestens einer Aussparung, in der wenigstens zwei in einem Teilbereich übereinander angeordnete integrierte Schaltkreise angeordnet sind, wobei wenigstens einer der Schaltkreise über Kopplungselemente mit externen Geräten kommunizieren kann, dadurch **gekennzeichnet,** daß die integrierten Schaltkreise (4, 7) über Mittel (9,11,13,16,17) verfügen, die eine Kommunikation zwischen den Schaltkreisen über eine nichtgalvanische, kontaktlose Kopplung ermöglichen.

2. Datenträger nach Anspruch 1, dadurch **gekennzeichnet,** daß die integrierten Schaltkreise direkt aneinander angrenzend übereinander angeordnet sind.

3. Datenträger nach Anspruch 2, dadurch **gekennzeichnet,** daß die integrierten Schaltkreise über eine Kleberschicht miteinander verbunden sind.

4. Datenträger nach Anspruch 2 oder 3, dadurch **gekennzeichnet,** daß die nichtgalvanische kontaktlose Kopplung zwischen den integrierten Schaltkreisen auf den einander zugewandten Flächen der integrierten Schaltkreise angeordnet ist.

5. Datenträger nach Anspruch 1, dadurch **gekennzeichnet,** daß die integrierten Schaltkreise räumlich getrennt voneinander im Datenträger angeordnet sind.

6. Datenträger nach Anspruch 5, dadurch **gekennzeichnet,** daß ein erster integrierter Schaltkreis (4) in einer Aussparung des Datenträgers angeordnet ist.

7. Datenträger nach Anspruch 6, dadurch **gekennzeichnet,** daß der zweite integrierte Schaltkreis (7) auf der dem ersten integrierten Schaltkreis gegenüberliegenden Seite des Datenträgers in einer zweiten Aussparung angeordnet ist.

8. Datenträger nach Anspruch 7, dadurch **gekennzeichnet**, daß die Aussparung durch ein Selbstklebeetikett (12) abgeklebt ist.

9. Datenträger nach Anspruch 6, dadurch **gekennzeichnet,** daß der zweite integrierte Schaltkreis integraler Bestandteil eines Selbstklebeetiketts ist, das auf der dem ersten integrierten Schaltkreis gegenüberliegenden Seite oder auf der Seite des ersten integrierten Schaltkreises aufgeklebt ist.

10. Datenträger nach Anspruch 5, dadurch **gekennzeichnet,** daß beide integrierten Schaltkreise integraler Bestandteil jeweils eines Selbstklebeetiketts sind, die entweder auf der gleichen Seite des Datenträgers oder auf gegenüberliegenden Seiten des Datenträgers aufgeklebt sind.

11. Datenträger nach Ansprüchen 1 - 10, dadurch **gekennzeichnet,** daß die Kopplung zwischen dem ersten integrierten Schaltkreis und dem zweiten integrierten Schaltkreis so ausgestaltet ist, daß ein Zugriff durch externe Geräte auf den zweiten integrierten Schaltkreis nur über den ersten integrierten Schaltkreis möglich ist.

12. Datenträger nach Ansprüchen 1 - 11, dadurch **gekennzeichnet,** daß die Kopplung zwischen den integrierten Schaltkreisen durch Spulen oder kapazitive Elemente oder Optokoppler erfolgt.

13. Datenträger nach den Ansprüchen 1 - 12, dadurch **gekennzeichnet**, daß Mittel (18) vorgesehen sind, die bei einem unrechtmäßigen Entfernen zumindest eines integrierten Schaltkreises vom Datenträger oder vom elektronischen Modul zur Unbrauchbarmachung wenigstens eines der integrierten Schaltkreise führt.

14. Elektronisches Modul zum Einbau in eine Aussparung eines Datenträgers gemäß Anspruch 1, umfassend einen ersten integrierten Schaltkreis und leitend mit dem ersten integrierten Schaltkreis verbundene Kopplungselemente zur Kommunikation mit externen Geräten, dadurch **gekennzeichnet,** daß der integrierte Schaltkreis (4) weiterhin über Mittel (9, 11,13,16,17) verfügt, die eine Kommunikation mit einem zweiten integrierten Schaltkreis, welcher ebenfalls Teil des Moduls ist, über eine nichtgalvanische, kontaktlose Kopplung ermöglichen und das elektronische Modul zumindest teilweise von einer Vergußmasse umgeben ist.

15. Elektronisches Modul gemäß Anspruch 14, dadurch **gekennzeichnet,** daß das Mittel eine Spule ist.

16. Elektronisches Modul nach Anspruch 15, dadurch **gekennzeichnet,** daß die Spule (11) in Form eines Bonddrahtes vorgesehen ist, der auf einer Oberfläche des ersten integrierten Schaltkreises angeordnet ist und dessen Enden leitend mit Anschlußpunkten (10) des integrierten Schaltkreises verbunden sind.

17. Elektronisches Modul nach Anspruch 15, dadurch **gekennzeichnet,** daß die Spule (9) aus einer Vielzahl von Bonddrähten besteht, deren Enden jeweils leitend mit dafür vorgesehenen Punkten des ersten integrierten Schaltkreises verbunden sind.

18. Elektronisches Modul nach Anspruch 15, dadurch **gekennzeichnet,** daß die Spule auf einem Spulenträger (3) des Moduls angeordnet ist, wobei die Enden der Spule leitend mit Anschlußpunkten des ersten integrierten Schaltkreises verbunden sind.

19. Elektronisches Modul gemäß Anspruch 14, dadurch **gekennzeichnet,** daß die Mittel Optokoppler oder kapazitive Elemente sind.

20. Elektronisches Modul gemäß Anspruch 14, 15 oder 19, dadurch **gekennzeichnet,** daß die Mittel monolithisch integriert im ersten Schaltkreis vorgesehen sind.

21. Elektronisches Modul nach Ansprüchen 14 - 20, dadurch **gekennzeichnet,** daß Teilbereiche des ersten integrierten Schaltkreises durch eine Vergußmasse vergossen sind, wobei ein zentraler innerer Teil auf der Oberfläche des ersten integrierten Schaltkreises frei von Vergußmasse ist.

22. Elektronisches Modul nach Anspruch 14, dadurch **gekennzeichnet,** daß der zweite integrierter Schaltkreis direkt angrenzend auf dem ersten integrierten Schaltkreis angeordnet ist und über Mittel verfügt, die eine Kommunikation mit dem ersten integrierten Schaltkreis über eine nichtgalvanische, kontaktlose Kopplung ermöglichen.

## Claims

1. A data carrier having at least one gap in which at least two integrated circuits disposed one on the other in a partial area are disposed, at least one of the circuits being able to communicate with external devices via coupling elements, characterized in that the integrated circuits (4, 7) have means (9, 11, 13, 16, 17) which permit communication between the circuits via a nongalvanic, contactless coupling.

2. The data carrier of claim 1, characterized in that the integrated circuits are disposed one on the other directly adjacent each other.

3. The data carrier of claim 2, characterized in that the integrated circuits are interconnected via an adhesive layer.

4. The data carrier of claim 2 or 3, characterized in that the nongalvanic contactless coupling between the integrated circuits is disposed on the opposing surfaces of the integrated circuits.

5. The data carrier of claim 1, characterized in that the integrated circuits are disposed in the data carrier spatially separated from each other.

6. The data carrier of claim 5, characterized in that a first integrated circuit (4) is disposed in a gap of the data carrier.

7. The data carrier of claim 6, characterized in that the second integrated circuit (7) is disposed on the side of the data carrier opposite the first integrated circuit in a second gap.

8. The data carrier of claim 7, characterized in that the gap is covered by a self-adhesive label (12).

9. The data carrier of claim 6, characterized in that the second integrated circuit is an integral part of a self-adhesive label which is glued to the side opposite the first integrated circuit or to the side of the first integrated circuit.

10. The data carrier of claim 5, characterized in that the integrated circuits are each an integral part of a self-adhesive label, the labels being glued either to the same side of the data carrier or to opposite sides of the data carrier.

11. The data carrier of claims 1 to 10, characterized in that the coupling between the first integrated circuit and the second integrated circuit is designed such that external devices can access the second integrated circuit only via the first integrated circuit.

12. The data carrier of claims 1 to 11, characterized in that the coupling between the integrated circuits is effected by coils or capacitive elements or optocouplers.

13. The data carrier of claims 1 to 12, characterized in that means (18) are provided which cause at least one of the integrated circuits to be rendered useless upon unlawful removal of at least one integrated circuit from the data carrier or from the electronic module.

14. An electronic module for incorporation in a gap of the data carrier of claim 1, comprising a first integrated circuit and coupling elements connected electrically with the first integrated circuit for communication with external devices, characterized in that the integrated circuit (4) further has means (9, 11, 13, 16, 17) which permit communication with a second integrated circuit, which is likewise part of the module, via a nongalvanic, contactless coupling, and the electronic module is at least partly surrounded by a casting compound.

15. The electronic module of claim 14, characterized in that the means are a coil.

16. The electronic module of claim 15, characterized in that the coil (11) is provided in the form of a bonding wire which is disposed on a surface of the first integrated circuit and whose ends are connected electrically with terminals (10) of the integrated circuit.

17. The electronic module of claim 15, characterized in that the coil (9) consists of a plurality of bonding wires whose ends are each connected electrically with points of the first integrated circuit intended therefor.

18. The electronic module of claim 15, characterized in that the coil is disposed on a coil carrier (3) of the module, the ends of the coil being connected electrically with terminals of the first integrated circuit.

19. The electronic module of claim 14, characterized in that the means are optocouplers or capacitive elements.

20. The electronic module of claim 14, 15 or 19, characterized in that the means are monolithically integrated in the first circuit.

21. The electronic module of claims 14 to 20, characterized in that partial areas of the first integrated circuit are cast by a casting compound while a central inner part on the surface of the first integrated circuit is free from casting compound.

22. The electronic module of claim 14, characterized in that the second integrated circuit is disposed directly adjacent on the first integrated circuit and has means permitting communication with the first integrated circuit via a nongalvanic, contactless coupling.

## Revendications

1. Support de données présentant au moins une cavité dans laquelle sont disposés au moins deux circuits intégrés agencés l'un sur l'autre dans une zone partielle, dans lequel au moins l'un des circuits peut communiquer via des éléments d'accouplement avec des appareils extérieurs, caractérisé en ce que les circuits intégrés (4,7) comportent des moyens (9,11,13,16,17) qui permettent une communication entre les circuits par un couplage non galvanique et sans contact.

2. Support de données selon la revendication 1, caractérisé en ce que les circuits intégrés sont disposés directement adjacents l'un contre l'autre et l'un au dessus de l'autre.

3. Support de données selon la revendication 2, caractérisé en ce que les circuits intégrés sont reliés l'un à l'autre via une couche adhésive.

4. Support de données selon la revendication 2 ou 3, caractérisé en ce que le couplage non galvanique et sans contact entre les circuits intégrés est disposé sur les surfaces en vis-à-vis des circuits intégrés.

5. Support de données selon la revendication 1, caractérisé en ce que les circuits intégrés sont disposés dans le support de données en étant spatialement séparés l'un de l'autre.

6. Support de données selon la revendication 5, caractérisé en ce qu'un premier circuit intégré (4) est disposé dans une cavité du support de données.

7. Support de données selon la revendication 6, caractérisé en ce que le deuxième circuit intégré (7) est disposé sur la face du support de données opposée au premier circuit intégré dans une deuxième cavité.

8. Support de données selon la revendication 7, caractérisé en ce que la cavité est fermée par collage à l'aide d'une étiquette autocollante (12).

9. Support de données selon la revendication 6, caractérisé en ce que le deuxième circuit intégré est un composant intégré d'une étiquette autocollante, qui est collée sur la face opposée au premier circuit intégré ou sur la face du premier circuit intégré.

10. Support de données selon la revendication 5, caractérisé en ce que les deux circuits intégrés sont chacun un composant intégré d'une étiquette autocollante, qui est collée soit sur la même face du support de données soit sur la face opposée du support de données.

11. Support de données selon les revendications 1 à 10, caractérisé en ce que le couplage entre le premier circuit intégré et le deuxième circuit intégré est agencé de telle façon qu'un accès par des appareils extérieurs au deuxième circuit intégré ne soit possible que via le premier circuit intégré.

12. Support de données selon les revendications 1 à 11, caractérisé en ce que le couplage entre les circuits intégrés est réalisé par des bobines ou par des éléments capacitifs ou par couplage optique.

13. Support de données selon les revendications 1 à 12, caractérisé en ce que sont prévus les moyens (18), qui en cas d'éloignement frauduleux d'au moins un circuit intégré hors du support de données ou du module électronique provoque la mise hors service ou rende inutilisable au moins l'un des circuits intégrés.

14. Module électronique destiné à être monté dans une cavité d'un support de données selon la revendication 1, comprenant un premier circuit intégré et des éléments de couplage reliés de façon conductrice au premier circuit intégré pour la communication avec des appareils extérieurs, caractérisés en ce que le circuit intégré (4) comporte en outre des moyens (9,11,13,16,17) qui permettent une communication via un couplage non galvanique et sans contact avec un deuxième circuit intégré, qui constitue également une partie du module, et en ce que le module électronique est entouré au moins partiellement par une masse coulée.

15. Module électronique selon la revendication 14, caractérisé en ce que les moyens sont constitués par une bobine.

16. Module électronique selon la revendication 15, caractérisé en ce que la bobine (11) est réalisée sous la forme d'un fil collé qui est disposé sur la surface du premier circuit intégré et dont les extrémités sont reliés de façon conductrice aux points (10) de raccordement du circuit intégré.

17. Module électronique selon la revendication 15, caractérisé en ce que la bobine (9) se compose d'une pluralité de fils collés, dont chacune des extrémités sont reliées de façon conductrice à des points prévus à cet effet du premier circuit intégré.

18. Module électronique selon la revendication 15, caractérisé en ce que la bobine est disposée sur un support de bobine (3) du module et en ce que les extrémités de la bobine sont reliées de façon conductrice aux points de raccordement du premier circuit intégré.

19. Module électronique selon la revendication 14, caractérisé en ce que les moyens sont des coupleurs optiques ou des éléments capacitifs.

20. Module électronique selon la revendication 14,15 ou 19, caractérisé en ce que les moyens sont prévus intégrés de façon monolithique dans le premier circuit intégré.

21. Module électronique selon les revendications 14 à 20, caractérisé en ce que des zones partielles du premier circuit intégré sont moulées par une masse coulée, une partie intérieure centrale à la surface du premier circuit intégré étant exempte de masse coulée.

22. Module électronique selon la revendication 14, caractérisé en ce que le deuxième circuit intégré est disposé directement adjacent au premier circuit intégré et comporte des moyens qui permettent une communication avec le premier circuit intégré via un couplage non galvanique et sans contact.
